# EUROPEAN PATENT APPLICATION

(11) **EP 2 028 864 A2**
(43) Date of publication of application: **25.02.2009**
(21) Application number: 08152809.3
(22) Date of filing: 14.03.2008
(51) Int. Cl.: H04N 7/26, H04N 5/45

(54) **Image transfer device and method thereof, and computer readable medium**

(30) Priority: 29.06.2007 JP 2007172467
(71) Applicant: Kabushiki Kaisha Toshiba, Minato-ku Tokyo (JP)
(72) Inventor: Yamaguchi, Kensaku, Toyko (JP)
(74) Representative: Jenkins, Peter David

(57) **Abstract**

There is provided with an image transfer device which communicates with a screen display device displaying image data on a screen thereof, including: an image data generator configured to generate image data corresponding to a plurality of divided areas into which the screen is divided, respectively; a data compression processor configured to compress generated image data corresponding to respective divided areas by using dictionary data obtained based on a predetermined amount of image data compressed in the past corresponding to the respective divided areas so that compressed image data corresponding to the respective divided areas are generated; and a data transmission unit configured to transmit the compressed image data corresponding to the respective divided areas to the screen display device.

## Description

### BACKGROUND OF THE INVENTION

### Field of the Invention

The present invention relates to an image transfer device and a method thereof, and a computer readable medium storing a program for image transfer.

### Related Art

Image transfer systems which compress a time-varying screen content of a personal computer and transmit the screen content in real time use a reversible data compression or irreversible data compression algorithm to compress image data.

One of frequently used reversible data compression algorithms is an LZ77 method (slide dictionary method) (see Jacob Ziv and Abraham Lempel, "A Universal Algorithm for Sequential Data Compression", IEEE Transactions on Information Theory, Vol. IT-23, No3, pp. 337-343, May 1977).

The LZ77 method uses a certain amount of most recently encoded or decoded data as dictionary data when carrying out compression (encoding) and expansion (decoding) processing.

To improve a hit rate of the dictionary and obtain a high compression rate, it is necessary to continuously give data having a likelihood that identical character strings may appear repeatedly as input data. On the contrary, alternately arranging data from mutually independent sources and encoding the data reduces the compression rate.

Therefore, as in the case of an image transfer system, when both the transmitting side and receiving side of a transmission path attempt to reduce the amount of data transmitted/received using a data compression technique, if there are a plurality of data sources of different properties, it is more likely to achieve a high compression rate by assigning different special dictionaries to the data sources, compressing the data separately and multiplexing the compressed data rather than compressing the data from all the sources using the same dictionary.

Considering image data displayed on a personal computer screen handled by an image transfer system, when only a narrow part of the screen area is viewed, it is often the case that all image data in the area is, for example, part of an identical graphic, and similar contents are arranged.

However, when the whole screen is viewed, images of different properties such as characters and graphics are displayed in different areas, and therefore the method of compressing image data of all areas using a single dictionary may not be able to obtain an optimum compression rate.

### SUMMARY OF THE INVENTION

According to an aspect of the present invention, there is provided with an image transfer device which communicates with a screen display device displaying image data on a screen thereof, comprising:
an image data generator configured to generate image data corresponding to a plurality of divided areas into which the screen is divided, respectively;
a data compression processor configured to compress generated image data corresponding to respective divided areas by using dictionary data obtained based on a predetermined amount of image data compressed in the past corresponding to the respective divided areas so that compressed image data corresponding to the respective divided areas are generated; and
a data transmission unit configured to transmit the compressed image data corresponding to the respective divided areas to the screen display device.

According to an aspect of the present invention, there is provided with an image transfer device which communicates with a screen display device displaying image data on a screen thereof, comprising:
an image data generator configured to generate image data corresponding to a plurality of windows to be displayed on the screen, respectively;
a data compression processor configured to compress generated image data corresponding to respective windows by using dictionary data obtained based on a predetermined amount of image data compressed in the past corresponding to the respective windows so that compressed image data corresponding to the respective windows are generated; and
a data transmission unit configured to transmit the compressed image data corresponding to the respective windows to the screen display device.

According to an aspect of the present invention, there is provided with an image transfer device which communicates with a screen display device displaying image data on a screen thereof, comprising:
an image data generator configured to generate image data corresponding one or more applications each including one or more windows to be displayed on the screen, respectively;
a data compression processor configured to compress generated image data corresponding to respective applications by using dictionary data obtained based on a predetermined amount of image data compressed in the past corresponding to the respective applications so that compressed image data corresponding to the respective applications are generated; and
a data transmission unit configured to transmit the compressed image data corresponding to the respective applications to the screen display device.

According to an aspect of the present invention, there is provided with an image transfer device which communicates with a screen display device displaying image data on a screen thereof, comprising:
an image data generator configured to generate image data to be displayed on the screen in accordance with each of a plurality of types of drawing instructions;
a data compression processor configured to compress generated image data corresponding to respective types of drawing instructions by using dictionary data obtained based on a predetermined amount of image data compressed in the past corresponding to the respective types of drawing instructions so that compressed image data corresponding to the respective types of drawing instructions are generated; and
a data transmission unit configured to transmit the compressed image data corresponding to the respective types of drawing instructions to the screen display device.

According to an aspect of the present invention, there is provided with an image transfer method of transferring image data to a screen display device displaying image data on a screen thereof, comprising:
generating image data corresponding to a plurality of divided areas into which the screen is divided, respectively;
compressing generated image data corresponding to respective divided areas by using dictionary data obtained based on a predetermined amount of image data compressed in the past corresponding to the respective divided areas so that compressed image data corresponding to the respective divided areas are generated; and
transmitting the compressed image data corresponding to the respective divided areas to the screen display device.

According to an aspect of the present invention, there is provided with a computer readable medium storing a computer program for causing a computer communicating with a screen display device displaying image data on a screen thereof, to execute instructions to perform the steps of:
generating image data corresponding to a plurality of divided areas into which the screen is divided, respectively;
compressing generated image data corresponding to respective divided areas by using dictionary data obtained based on a predetermined amount of image data compressed in the past corresponding to the respective divided areas so that compressed image data corresponding to the respective divided areas are generated; and
transmitting the compressed image data corresponding to the respective divided areas to the screen display device.

### BRIEF DESCRIPTION OF THE DRAWINGS

FIG. 1 shows the configuration of an image transfer system according to a first embodiment of the present invention;
FIG. 2 shows the configuration of an image transfer device as the first embodiment of the present invention;
FIG. 3 shows a method of allocating image data according to the first embodiment;
FIG. 4 illustrates an example where a plurality of dictionary memories are assigned to one rectangular area; and
FIG. 5 illustrates a method of allocating image data according to a second embodiment.

### DETAILED DESCRIPTION OF THE INVENTION

### (First embodiment)

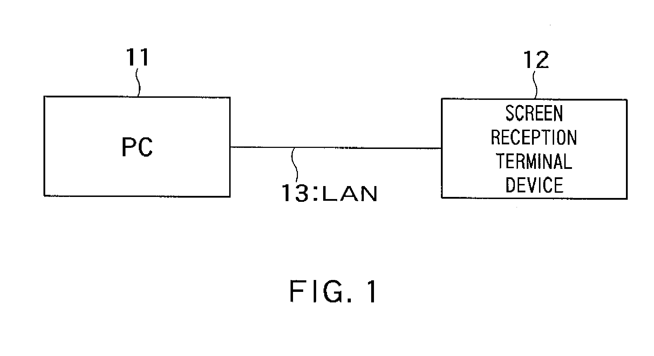

FIG. 1 shows a schematic configuration of an image transfer system according to this embodiment. In FIG. 1, a personal computer (PC) 11 and a screen reception terminal device (screen display device) 12 are connected together via a LAN (Local Area Network) 13. The PC 11 corresponds, for example, to an image transfer device.

The PC 11 incorporates not only a general application program but also a program which transmits a screen and executes this program to thereby compress image data indicating the content displayed on a screen of the PC 11 to generate compressed image data and transmit the compressed image data to the screen reception terminal device 12 via the LAN 13.

The screen reception terminal device 12 receives the compressed image data from the PC 11, expands and displays the image data on the screen.

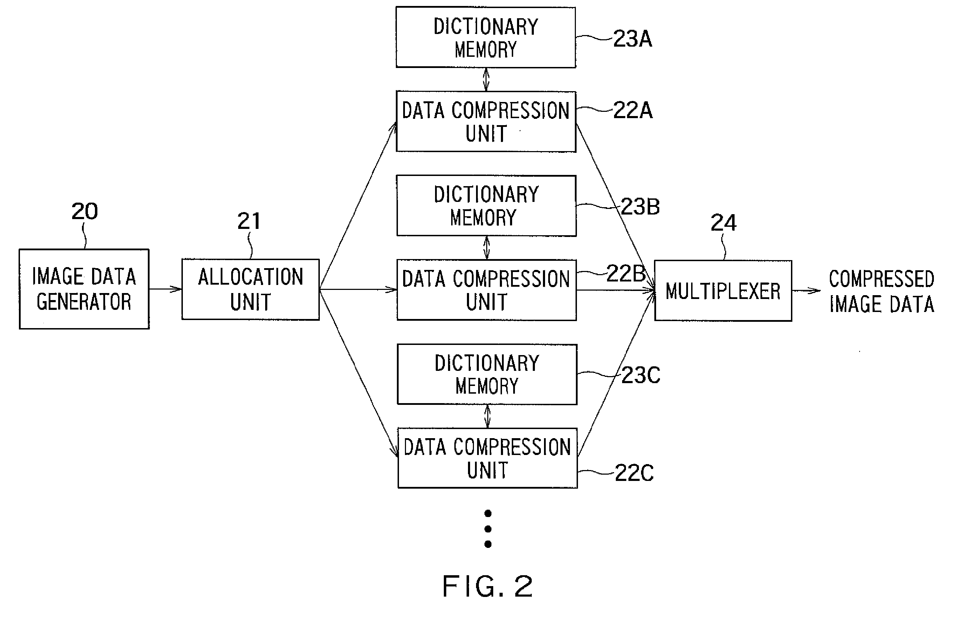

FIG. 2 is a functional block diagram of the PC 11 and especially shows only parts related to the present invention.

An image data generator 20 generates image data to be displayed on the screen of the screen reception terminal device (screen display device) 12 and inputs the image data generated to an allocation unit 21. The image data is image data of a whole screen or image data of an updated part of the whole screen. The image data is allocated to a plurality of data compression units 22A, 22B, 22C, ... by the allocation unit 21.

The data compression unit 22A compresses the image data sent from the allocation unit 21 with reference to a dictionary memory 23A and updates reference data (dictionary data) used for compression stored in the dictionary memory 23A with the latest content. More specifically, the data compression unit 22A updates the dictionary memory 23A so that a certain amount of image data compressed in the past is always kept as dictionary data. The certain amount of image data compressed in the past is, for example, a certain amount of image data compressed immediately before compressing image data.

The data compression unit 22B, data compression unit 22C, ... and dictionary memory 23B, dictionary memory 23C, ... are similar to the data compression unit 22A and dictionary memory 23A.

The data compressed by each data compression unit (compressed image data) is multiplexed by a multiplexer (data transmission unit) 24 and then sent to the LAN 13.

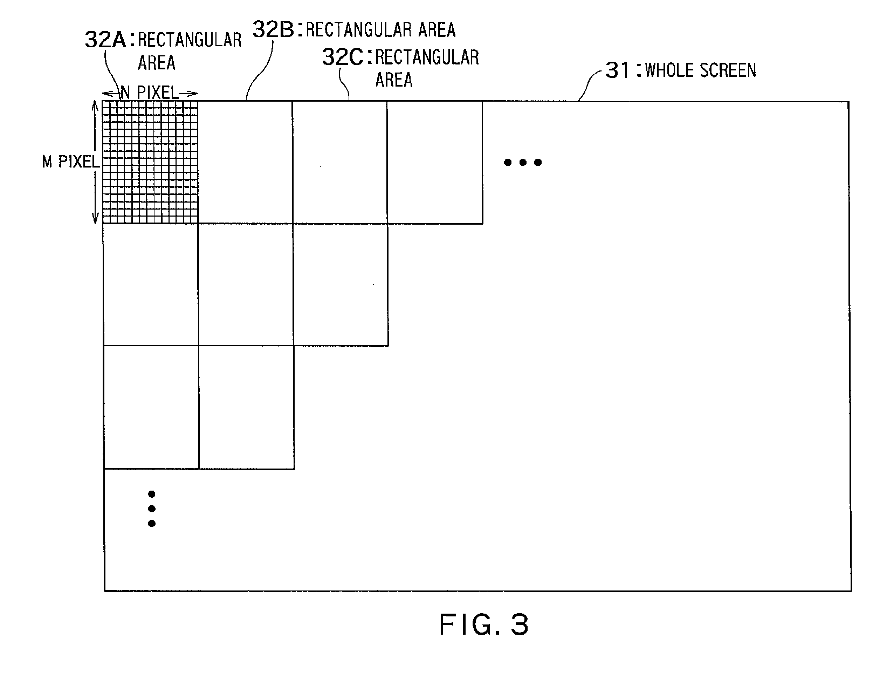

FIG. 3 illustrates the operation (method of allocating image data according to the first embodiment) of the allocation unit 21.

As shown in FIG. 3, a whole screen 31 in the PC 11 or screen reception terminal device 12 is divided into small rectangular areas (divided areas) 32A, 32B, 32C, ..., each having N pixels in the horizontal direction and M pixels in the vertical direction.

Here, the values of N and M are selected so that the value obtained by multiplying a product NxM by the amount of data per pixel becomes equal to or smaller than the capacity sizes of the memories 23A, 23B, 23C, ... used as dictionaries.

In this embodiment, one dictionary memory is assigned to each rectangular area. For example, the dictionary memory 23A is assigned to the rectangular area 32A and the dictionary memory 23B is assigned to the rectangular area 32B.

When the screen content is updated and image data is compressed, the allocation unit 21 decides to which rectangular area the image data belongs and allocates the image data so that the image data is compressed by the dictionary memory corresponding to the rectangular area. When the image data extends over a plurality of rectangular areas, the image data is divided by the rectangular areas and the divided image data are allocated to the respective rectangular areas.

Here, the plurality of data compression units 22A, 22B, 22C, ... in FIG. 2 can be integrated into one data compression processor (however, the dictionary memories remain plural). In this case, the data compression processor can specify a dictionary memory to be used for compression depending on to which rectangular area the image data belongs and compress the image data using the dedicated dictionary memory.

Adopting a configuration described in the above can produce an effect of improving the image data compression rate as shown in the following example.

When a connection between the PC 11 and screen reception terminal device 12 is started for the first time, the image data of the whole content of the screen is sent. Since the image data to be sent extends over a plurality of rectangular areas, the allocation unit 21 divides the image data into the rectangular areas 32A, 32B, 32C, .... The image data which belong to the rectangular areas 32A, 32B, 32C, ... are compressed by the data compression units 22A, 22B, 22C, .... Furthermore, the data in the most recently compressed dictionary size is stored in the dictionary memories 23A, 23B, 23C, ... according to the algorithm of LZ77 method. Since the size of the image data before compression is equal to or smaller than the size of the dictionary memory, all image data in sizes of the rectangular areas 32A, 32B, 32C, ... can be stored in the dictionary memories 23A, 23B, 23C, ....

Next, the screen content of the rectangular area 32A is updated, and as a result, the image data corresponding to the rectangular area 32A is compressed. In many cases, the image before an update and the image after an update have many common parts in their contents. For example, when the screen content is scrolled in the vertical direction or horizontal direction, the scrolled screen content simply corresponds to the screen content before scrolling shifted by several pixels and contents other than edges of the area viewed in the scrolling direction are common. Therefore, when the image data after updating the rectangular area 32A is compressed using the dictionary memory 23A, compression at an extremely high compression rate can be expected. Furthermore, also when the image data corresponding to the rectangular area 32A is continuously compressed by updating the screen content, a similarly high compression rate can be expected. Incidentally, when compression is performed with one dictionary memory assigned to the whole screen without dividing the whole screen, the content of the dictionary memory is likely to be data in an area irrelevant to the data to be compressed from now on, and therefore the above described high compression rate cannot be normally obtained.

In the above described explanation, the ratio of vertical and horizontal lengths M, N of the respective rectangular areas is arbitrary, but when it is estimated that the frequency with which a scroll operation of the screen content in any one of the up/down direction and left/right direction is higher than that in the other direction, setting the ratio of M and N so that the side in that direction becomes longer than an other side in the other direction allows a further higher compression effect to be obtained.

For example, when it is estimated that scrolling in the vertical direction is performed with higher frequency than scrolling in the horizontal direction, the length M of the vertical side of each rectangular area is made greater than the length N of the horizontal side. However, suppose the value M×N is fixed.

This makes it possible to reduce the area of the parts of edges of the scrolling area not remaining in the dictionary memories out of the updated image data when scrolling is performed (that is, increase the area of the part remaining in the dictionary memories) and therefore the effect of the compression rate is higher compared to the case where, for example, the rectangular area is similar to a square.

The example where one dedicated dictionary memory is assigned to each rectangular area has been explained above, but examples where a plurality of dictionary memories are assigned to one rectangular area will be shown as Nos.1, 2 and 3 below.

### (No.1)

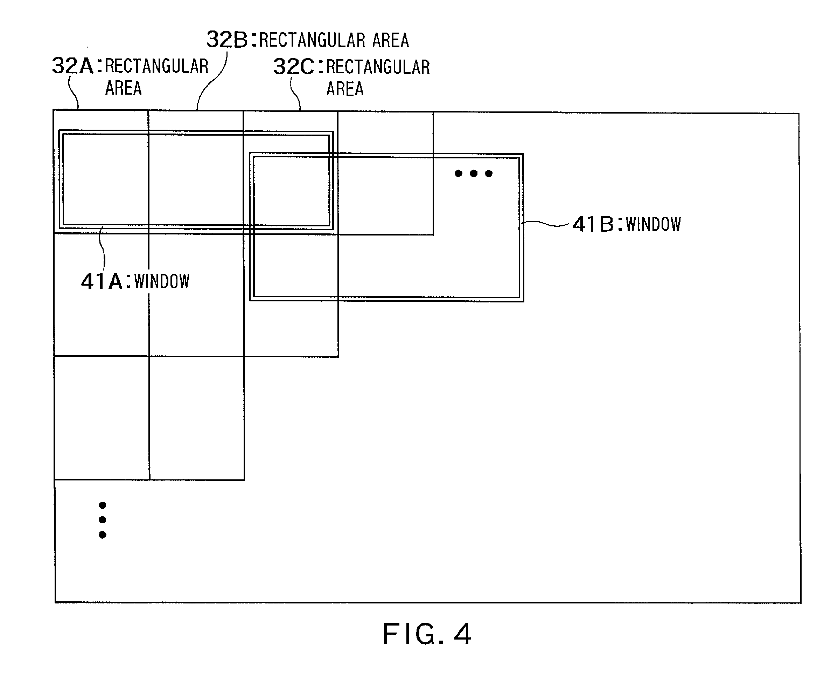

FIG. 4 shows a screen example where a window system is used. Two windows, that is, window 41A and window 41B overlap each other inside a rectangular area 32C.

By switching between the windows displayed uppermost out of the window 41A and window 41B, the content displayed in the overlapping part of the windows 41A and 41B inside the rectangular area 32C is changed.

In such a case, instead of assigning one dictionary memory to the rectangular area, the same number of dictionary memories as the windows overlapping each other in the rectangular area are assigned so as to correspond to the respective windows.

Since two windows overlap each other in the rectangular area 32C, two dictionary memories are assigned to this rectangular area 32C. That is, two dictionary memories 23C and 23C' are assigned to the data compression unit 22C. The dictionary memory 23C is assigned to the window 41A and the dictionary memory 23C' is assigned to the window 41B. Here, it is assumed that the same number of dictionary memories as windows are assigned to one data compression unit, but the same number of sets of data compression unit and dictionary memory as windows may also be allocated to the respective windows and data may be allocated to the respective data compression units according to the window displayed uppermost. The same will also apply to (No.2) and (No.3) which will be described later.

When the screen content is updated and image data is compressed, if the image data is decided to belong to the rectangular area 32C, the allocation unit 21 examines the window displayed uppermost and sends an instruction and image data to the data compression unit 22C so that the dictionary memory 23C is used when the window 41A is displayed uppermost or dictionary memory 23C' is used when the window 41B is displayed uppermost. Alternatively, when the data compression units are arranged in the dictionary memories 23C and 23C' respectively, the allocation unit 21 allocates the image data to the data compression unit corresponding to the dictionary memory 23C when the window 41A is displayed uppermost and allocates the image data to the data compression unit corresponding to the dictionary memory 23C' when the window 41B is displayed uppermost.

By so doing, when the window to be displayed uppermost is switched, the dictionary memory used to compress the screen content of the window is used again, and therefore a higher compression rate is obtained than when there is only one dictionary memory.

### (No.2)

When the screen content is updated and the image data is compressed, if the image data is decided to belong to the rectangular area 32C, the allocation unit 21 examines whether or not the image data is included in an actually displayed area out of the area of the window 41A and an actually displayed area out of the area of the window 41B in the rectangular area 32C.

When the image data is included in the actually displayed area of the window 41A and not included in the actually displayed area of the window 41B, an instruction and the image data are sent to the data compression unit 22C so that the dictionary memory 23C is used. Alternatively, when the data compression units are arranged in both the dictionary memories 23C and 23C', the allocation unit 21 allocates the image data to the data compression unit corresponding to the dictionary memory 23C.

When the image data is included in the actually displayed of the window 41B and not included in the actually displayed area of the window 41A, an instruction and the image data are sent to the data compression unit 22C so that the dictionary memory 23C' is used. Alternatively, when the data compression units are arranged in the dictionary memories 23C and 23C' respectively, the allocation unit 21 allocates the image data to the data compression unit corresponding to the dictionary memory 23C'.

When the image data is included so as to extend over the actually displayed areas of both the windows 41A and 41B or included in none of the actually displayed areas of the two windows, an instruction and the image data are sent to the data compression unit 22C so that any one of the dictionary memory 23C and the dictionary memory 23C' is used. Alternatively, when the data compression units are arranged in the dictionary memories 23C and 23C' respectively, the allocation unit 21 allocates the image data to the data compression unit corresponding to any one of the dictionary memories 23C and 23C'. For example, the dictionary memory 23C may always be used, or when the image data is included so as to extend over the actually displayed areas of both windows, the dictionary memory corresponding to the window with the greater area of inclusion may be used.

### (No.3)

When the screen content is updated and the image data is compressed, if the image data is decided to belong to the rectangular area 32C, the allocation unit 21 examines whether or not the image data is included in the actually displayed area of the window 41A and in the actually displayed area of the window 41B respectively in the rectangular area 32C.

When the image data is included in the actually displayed area of the window 41A and not included in the actually displayed area of the window 41B, an instruction and the image data are sent to the data compression unit 22C so that the dictionary memory 23C is used. Alternatively, when the data compression unit is arranged in the dictionary memories 23C, 23C' respectively, the allocation unit 21 allocates the image data to the data compression unit corresponding to the dictionary memory 23C.

When the image data is included in the actually displayed area of the window 41B and not included in the actually displayed area of the window 41A, an instruction and the image data are sent to the data compression unit 22C so that the dictionary memory 23C' is used. Alternatively, when the data compression unit is arranged in the dictionary memories 23C, 23C' respectively, the allocation unit 21 allocates the image data to the data compression unit corresponding to the dictionary memory 23C'.

When the image data is included so as to extend over the actually displayed areas of both the windows 41A and 41B, the image data is divided into a plurality of portions so that each portion (divided image data) does not extend over more than one window (i.e. each portion is separated between windows) and a plurality of divided pieces of image data are generated. Dictionary memories to be used are then used differently for each portion of the divided image data as described above.

When the image data is included in none of the actually displayed areas of the windows, an instruction and the image data are sent to the data compression unit 22C so that any one of the dictionary memory 23C and dictionary memory 23C' is used. Alternatively, when the data compression units are arranged in the dictionary memories 23C and 23C' respectively, the allocation unit 21 allocates the image data to the data compression unit corresponding to any one of the dictionary memories 23C and 23C'. For example, the dictionary memory 23C may always be used.

### (Second embodiment)

This embodiment is characterized by assigning a dedicated dictionary memory to each window. Hereinafter, this embodiment will be explained in detail.

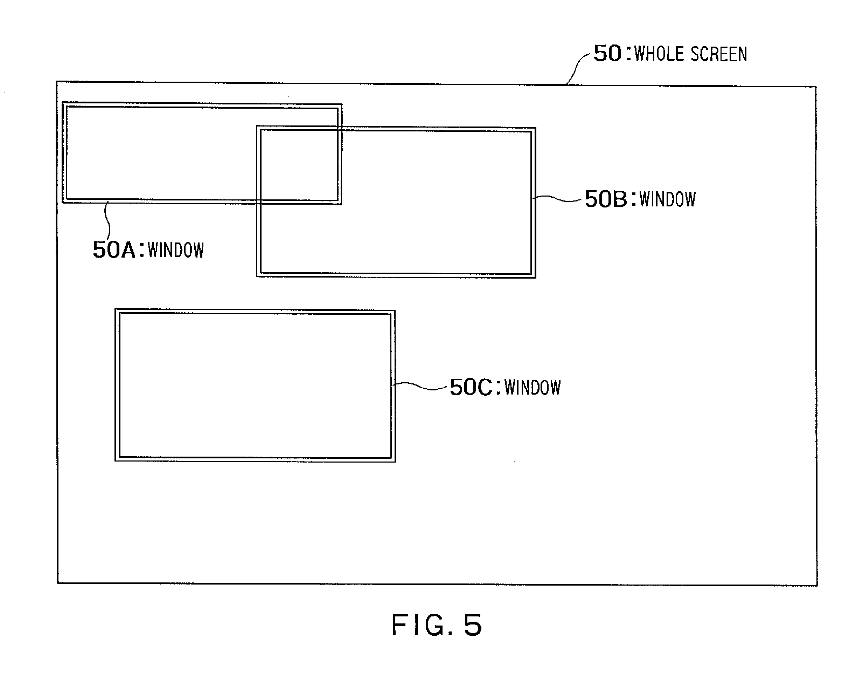

FIG. 5 illustrates a method of allocating image data according to the second embodiment. FIG. 5 shows a screen example where a window system is used. Several windows, that is window 50A, window 50B, window 50C, ... are displayed in the whole screen 50.

The data compression unit 22A and dictionary memory 23A are allocated to the window 50A, the data compression unit 22B and dictionary memory 23B are allocated to the window 50B and the data compression unit 22C and dictionary memory 23C are allocated to the window 50C. Furthermore, the data compression units and dictionary memories are also allocated to the remaining areas which are different from the areas of the windows 50A, 50B and 50C of the whole screen 50.

When the screen content is updated and the image data is compressed, the allocation unit 21 decides which window the image data belongs to and allocates the image data so that the image data is compressed with the dictionary memory corresponding to the decided window. When, for example, the image data is decided to belong to the window 50A, the image data is allocated to the data compression unit 22A so that the dictionary memory 23A is used. When the image data does not belong to any window, the image data is allocated to the data compression unit so that the image data is compressed by the dictionary memory allocated to the above described remaining area. As in the case of the first embodiment, the data compression units corresponding to the respective dictionary memories may be integrated into one data compression processor (however, the dictionary memories remain plural).

By so doing, images of similar contents, for example, partial images of the same graphic are likely to be drawn in the same window, and therefore a high compression rate is obtained compared to the case where the same dictionary memory is allocated to the set of all windows or the whole screen.

The example where a dictionary memory is allocated to each window has been shown above, but when the same application program displays a plurality of windows, a dictionary memory and data compression unit may also be allocated to each application program. The data compression units corresponding to the respective dictionary memories may also be integrated into one data compression processor.

Furthermore, even when one window is divided into several areas by a function of coordination between application programs and a plurality of application programs are performing drawing on the respective areas in one window, a data compression unit and a dictionary memory may be likewise allocated to each application program included in one window. The respective data compression units may be integrated into one data compression processor in this case, too.

### (Third embodiment)

This embodiment is characterized by providing the same number of dictionary memories as types of drawing instruction triggering an update of a screen content and allocating dictionary memories to the types of respective drawing instructions. The data compression units may be allocated to the respective dictionary memories or these may be integrated into one data compression processor.

Types of drawing instruction include text drawing, rectangle drawing, bitmap image drawing and the like. The drawn area and drawing content are determined depending on a drawing instruction. An image data generator 20 generates image data to be displayed on a screen display device using a plurality of types of drawing instruction.

When a screen content is updated and image data is compressed, an allocation unit 21 examines the type of drawing instruction triggering an update of a screen content about the updated image data and allocates the image data to the data compression unit so that the image data are compressed by dictionary memory corresponding to the type. The type of drawing instruction triggering an update of a screen content can be identified by, for example, querying the image data generator 20 or by including the type of image data in the drawing instruction sent from the image data generator 20 to the allocation unit 21.

Screen contents drawn by the same type of drawing instruction are considered to have a high possibility of containing many common parts. For example, in the case of text drawing, the same font, character color and background color are often used, and in the case of button drawing, the design of the outside shape except the button label is often the same. Therefore, using different dictionary memories case by case can achieve a higher compression rate than when using a single dictionary memory.

As described above, according to the first to third embodiments of the present invention, using a plurality of different dictionary memories on a case-by-case basis efficiently can obtain a higher compression rate than when using a single dictionary memory. Since the amount of transmission data is reduced, it is possible to improve a reaction speed and update frequency when updating the screen and reduce communication cost.

Incidentally, this image transfer device may also be implemented by using, for example, a general-purpose computer device as basic hardware. That is, the image data generator, allocation unit, data compression unit and multiplexer can be implemented by causing a processor mounted in the above described computer device to execute a program. In this case, the screen transfer device may also be implemented by pre-installing the above described program in a computer device or by storing the program in a storage medium such as CD-ROM or distributing the above described program via a network and installing this program in a computer device as appropriate. Furthermore, the dictionary memories may be implemented by using a memory, hard disk incorporated in or externally attached to the above described computer device or a storage medium such as CD-R, CD-RW, DVD-RAM and DVD-R as appropriate.

## Claims

1. An image transfer device which communicates with a screen display device displaying image data on a screen thereof, comprising:
an image data generator configured to generate image data corresponding to a plurality of divided areas into which the screen is divided, respectively;
a data compression processor configured to compress generated image data corresponding to respective divided areas by using dictionary data obtained based on a predetermined amount of image data compressed in the past corresponding to the respective divided areas so that compressed image data corresponding to the respective divided areas are generated; and
a data transmission unit configured to transmit the compressed image data corresponding to the respective divided areas to the screen display device.

2. The device according to claim 1, further comprising a plurality of dictionary memories configured to store the predetermined amount of image data compressed in the past corresponding to the respective divided areas.

3. The device according to claim 1, wherein the dictionary memories has capacity sizes equal to or greater than sizes of image data corresponding to respective divided areas.

4. The device according to claim 2, wherein the data compression processor comprises a plurality of data compression units configured to compress the image data corresponding to the respective divided areas by using the dictionary memories corresponding to the respective divided areas.

5. The device according to claim 2, wherein a plurality of dictionary memories are provided for a first divided area correspondingly to a plurality of mutually overlapping windows in the first divided area, and
the data compression processor compresses the image data corresponding to the first divided area by using the dictionary memory corresponding to the window being displayed uppermost among the windows.

6. The device according to claim 2, wherein first and second dictionary memories are provided for a second divided area correspondingly to first and second windows being displayed in the second divided area;
the data compression processor
compresses the image data corresponding to the second divided area by using the first dictionary memory when the image data corresponding to the second divided area is included in a first area actually being displayed of the first window and not included in a second area being actually displayed of the second window,
compresses the image data corresponding to the second divided area by using the second dictionary memory when the image data corresponding to the second divided area is not included in the first area and included in the second area, and
compresses the image data corresponding to the second divided area by using one of the first and second dictionary memories when the image data corresponding to the second divided area extends over both the first and second areas or included in none of the first and second areas.

7. The device according to claim 2, wherein first and second dictionary memories are provided for a third divided area correspondingly to first and second windows displayed in the third divided area;
the data compression processor
compresses the image data corresponding to the third divided area by using the first dictionary memory when the image data corresponding to the third divided area is included in a first area being actually displayed of the first window and not included in a second area being actually displayed of the second window,
compresses the image data corresponding to the third divided area by using the second dictionary memory when the image data corresponding to the third divided area is not included in the first area and included in the second area,
when the image data corresponding to the third divided area extends over both the first and second display areas, divides the image data corresponding to the third divided area so as to be separated between the first and second areas to generate respective divided image data and compresses the divided image data corresponding to the first area by using the first dictionary memory and the divided image data corresponding to the second area by using the second dictionary memory, and
compresses the image data corresponding to the third divided area by using one of the first and second dictionary memories when the image data corresponding to the third divided area is included in none of the first and second areas.

8. The device according to claim 1, wherein the data compression processor uses a certain amount of image data compressed immediately before compressing the image data corresponding to the divided areas, as dictionary data for the divided areas.

9. The device according to claim 1, wherein one side of the divided area in a vertical or horizontal direction where the frequency with which the screen is scrolled is estimated to be high, is made longer than an other side in the other direction.

10. An image transfer device which communicates with a screen display device displaying image data on a screen thereof, comprising:
an image data generator configured to generate image data corresponding to a plurality of windows to be displayed on the screen, respectively;
a data compression processor configured to compress generated image data corresponding to respective windows by using dictionary data obtained based on a predetermined amount of image data compressed in the past corresponding to the respective windows so that compressed image data corresponding to the respective windows are generated; and
a data transmission unit configured to transmit the compressed image data corresponding to the respective windows to the screen display device.

11. An image transfer device which communicates with a screen display device displaying image data on a screen thereof, comprising:
an image data generator configured to generate image data corresponding one or more applications each including one or more windows to be displayed on the screen, respectively;
a data compression processor configured to compress generated image data corresponding to respective applications by using dictionary data obtained based on a predetermined amount of image data compressed in the past corresponding to the respective applications so that compressed image data corresponding to the respective applications are generated; and
a data transmission unit configured to transmit the compressed image data corresponding to the respective applications to the screen display device.

12. An image transfer device which communicates with a screen display device displaying image data on a screen thereof, comprising:
an image data generator configured to generate image data to be displayed on the screen in accordance with each of a plurality of types of drawing instructions;
a data compression processor configured to compress generated image data corresponding to respective types of drawing instructions by using dictionary data obtained based on a predetermined amount of image data compressed in the past corresponding to the respective types of drawing instructions so that compressed image data corresponding to the respective types of drawing instructions are generated; and
a data transmission unit configured to transmit the compressed image data corresponding to the respective types of drawing instructions to the screen display device.

13. An image transfer method of transferring image data to a screen display device displaying image data on a screen thereof, comprising:
generating image data corresponding to a plurality of divided areas into which the screen is divided, respectively;
compressing generated image data corresponding to respective divided areas by using dictionary data obtained based on a predetermined amount of image data compressed in the past corresponding to the respective divided areas so that compressed image data corresponding to the respective divided areas are generated; and
transmitting the compressed image data corresponding to the respective divided areas to the screen display device.

14. A computer readable medium storing a computer program for causing a computer communicating with a screen display device displaying image data on a screen thereof, to execute instructions to perform the steps of:
generating image data corresponding to a plurality of divided areas into which the screen is divided, respectively;
compressing generated image data corresponding to respective divided areas by using dictionary data obtained based on a predetermined amount of image data compressed in the past corresponding to the respective divided areas so that compressed image data corresponding to the respective divided areas are generated; and
transmitting the compressed image data corresponding to the respective divided areas to the screen display device.
